# FASCICULE DE BREVET EUROPEEN

(11) **EP 0 942 530 B1**
(45) Date de publication et mention de la délivrance du brevet: **16.03.2005**
(21) Numéro de dépôt: 99200615.5
(22) Date de dépôt: 03.03.1999
(51) Int. Cl.: H03H 17/02, H03H 17/06

(54) **Circuit processeur programmable muni d'une mémoire reconfigurable, pour réaliser un filtre numérique**
Programmierbare Verarbeitungsschaltung mit einem rekonfigurierbaren Speicher zur Darstellung eines digitalen Filters
Programmable processor circuit comprising a reconfigurable memory for the embodiment of a digital filter

(30) Priorité: 10.03.1998 FR 9802910
(43) Date de publication de la demande: 15.09.1999
(73) Titulaire: Koninklijke Philips Electronics N.V., 5621 BA Eindhoven (NL)
(72) Inventeur: Dujardin, Eric, 75008 Paris (FR); Gay-Bellile, Olivier, 75008 Paris (FR)
(74) Mandataire: Charpail, François

(56) Documents cités:
- EP-A- 0 732 809
- US-A- 4 757 519
- US-A- 5 438 532

## Description

La présente invention concerne un circuit co-processeur programmable destiné à être associé à un processeur principal pour constituer un filtre numérique, circuit comprenant au moins un élément processeur de filtrage contenant de la mémoire pour des données d'entrée et pour des coefficients, au moins un additionneur dont les entrées sont connectées aux sorties de lecture de la mémoire des données et un multiplieur dont une entrée est connectée à une sortie de résultat de l'additionneur et une autre entrée est connectée à une sortie de lecture de la mémoire de coefficients.

Un tel circuit est utilisé notamment dans des applications où plusieurs filtres sont nécessaires, telles que diverses applications dites "multimédia", par exemple pour réduire les interférences inter-symboles, pour changer le débit de données, ou pour réduire le bruit ajouté par un canal de communication.

Un filtre numérique comprend essentiellement une suite d'éléments entre lesquels sont prélevés des signaux qui sont traités, notamment multipliés par un coefficient et/ou additionnés, puis sont ré-injectés ailleurs. Pour réaliser des filtres numériques, on connaît trois voies :
- utiliser un processeur, du genre dit DSP, avec des algorithmes spécialisés de façon à constituer un filtre ; si cette voie offre une grande flexibilité, elle est par contre limitée du point de vue des performances des filtres, notamment en vitesse,
- utiliser des circuits spécialisés constituant directement des filtres ; cela permet de grandes performances mais conduit à développer de nombreux circuits différents,
- utiliser des circuits spécialisés, mais programmables ; cela procure un bon compromis entre les performances élevées des circuits spécialisés et la bonne flexibilité d'un DSP ; parmi les circuits spécialisés programmables, on distingue des filtres programmables à processeur, cela signifie qu'ils sont essentiellement constitués par un processeur DSP réduit au minimum requis par le processus mis en oeuvre dans un filtre. C'est la solution la plus intéressante.

Un circuit spécialisé programmable comprend des mémoires pour stocker des coefficients programmables. Il est en général configuré pour réaliser un type de filtre particulier : symétrique, demi-bande, d'interpolation, à décimation, adaptatif, complexe. Un filtre programmable à processeur est connu du document EP 0 732 809. Le processeur selon ce document est capable de calculer deux filtres montés en cascade, ayant la même fréquence d'horloge. Il utilise deux registres pour stocker les résultats partiels des deux filtres. Un circuit intégré pour un filtre programmable à processeur est connu de la demande de brevet Européen EP 0 454 050. Le circuit intégré selon ce document comprend un multiplieur et un additionneur, une mémoire pour le stockage de données et une mémoire de programme pour stocker ensemble les codes d'instructions et les valeurs de coefficients, et une mémoire pour des instructions lues dans la mémoire de programme, ce qui permet d'exécuter une instruction tout en lisant de façon continue les valeurs de coefficients. Il comporte des mémoires séparées pour les données et pour les coefficients, de manière à ne pas être obligé de lire les données à un temps différent de celui auquel les coefficients sont lus.

Un objet de invention est de fournir un circuit programmable qui permette le multiplexage de différents types de filtres en utilisant de manière optimale la mémoire, même quand ils ont différentes exigences en matière de taille de mémoire pour stocker les données et les coefficients.

A cet effet, la mémoire des données d'entrée et celle des coefficients est placée dans une mémoire unique qui est partitionnée en plusieurs parties possédant un nombre d'entrées-sorties limité, et des moyens sont prévus pour regrouper des parties de façon variable afin d'adapter de façon optimale la mémoire à des filtres différents.

L'idée de base de l'invention est donc de partager la mémoire entre les données et les coefficients en utilisant plusieurs mémoires, sans augmenter la taille de mémoire, ce qui permet, comme le montre un mode de mise en oeuvre décrit plus loin, d'utiliser par exemple seulement un port d'entrée et deux ports de sortie, de manière à avoir le maximum d'efficacité pour un coût plus réduit que celui d'une grande mémoire avec trois ports d'entrée et cinq ports de sortie. En effet, la surface d'une mémoire dépend beaucoup du nombre de ports.

Des modes particuliers de réalisation du circuit coprocesseur programmable apparaissent dans les revendications dépendantes 2 à 4.

Ces aspects de l'invention ainsi que d'autres aspects plus détaillés apparaîtront plus clairement grâce à la description suivante d'un mode de réalisation constituant un exemple non limitatif.
La figure 1 représente schématiquement un système de calcul de filtres comprenant plusieurs éléments processeurs de filtrage.
La figure 2 est un schéma plus détaillé d'un élément processeur de filtrage.
La figure 3 est un tableau des besoins en taille de mémoire, pour différents types de données, différents coefficients et différents types de filtres.
Les figures 4 et 5 illustrent chacune une variante d'organisation des mémoires dans un élément processeur de filtrage.

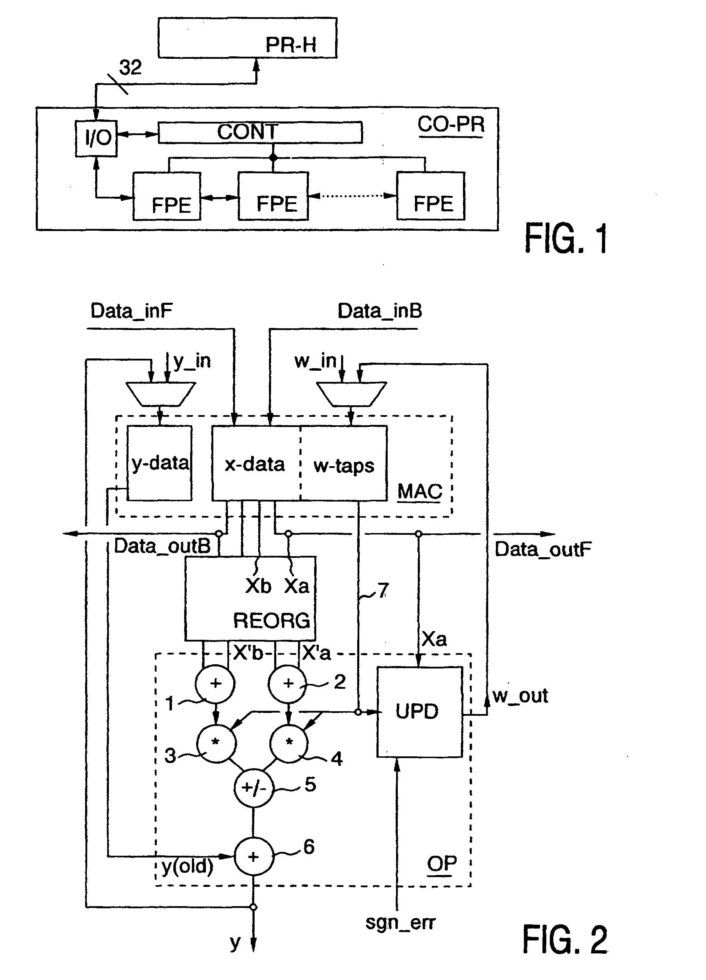

Le circuit CO-PR de la figure 1 est un coprocesseur associé avec un processeur hôte PR-H, et il communique avec lui via un bus à 32 bits, même lorsque le filtre numérique ne nécessite pas autant de bits en parallèle. Il comprend un bloc I/O qui synchronise les communications entre le processeur hôte et le coprocesseur, ainsi qu'un module de commande CONT qui enregistre les caractéristiques du filtre à réaliser et qui commande des éléments processeurs de filtrage FPE proprement dits. Plusieurs éléments processeurs de filtrage FPE sont prévus pour fournir la puissance de calcul nécessaire, leur nombre sera appelé nc.

L'élément processeur de filtrage de la figure 2 comprend deux parties principales: une partie opératrice OP et une partie mémoire MAC. La partie opératrice contient des multiplieurs et additionneurs requis pour calculer les filtres et des circuits logiques utilisés pour mettre à jour les coefficients des filtres adaptatifs. La partie mémoire contient une mémoire w-taps, pour mémoriser tous les coefficients utilisés par les différents filtres multiplexés, une mémoire x-data pour mémoriser toutes les données d'entrée utilisées par les filtres, et une mémoire y-data pour mémoriser les résultats intermédiaires de plusieurs filtres. Les mémoires y-data sont particulièrement destinées au calcul avec multiplexage. L'entrée w_in sert à initialiser la mémoire w-taps.

Des données sont transmises par deux lignes unidirectionnelles entre les éléments processeurs de filtrage : une ligne "aller" Data_inF/Data_outF et une ligne "retour" Data_inB/Data_outB. La ligne aller transmet des données de la gauche vers la droite. La ligne retour transmet des données de la droite vers la gauche ; cette ligne est utilisée seulement dans le cas de filtres symétriques. Les résultats sont transmis de la droite vers la gauche via les ports y_in et y.

Du fait qu'il y a plusieurs formats possibles pour les données, qu'une décimation peut être réalisée, et que les données peuvent être réelles ou complexes, un bloc de réorganisation de données REORG est prévu, muni de moyens pour recevoir des données d'entrée depuis la mémoire des données d'entrée x-data, pour les réorganiser et les fournir aux premier et second additionneurs, de façon à alimenter la partie opératrice avec des données adéquates. Des données Xa et Xb venant de la mémoire x-data, correspondant à celles transmises par la ligne aller, sont transformées en X'a et X'b par ce bloc de réorganisation.

La partie opératrice OP comprend deux additionneurs 1 et 2, chacun d'entre eux ayant sa sortie respectivement connectée à une entrée d'un multiplieur 3, 4 dont l'autre entrée reçoit, via une connexion 7, une valeur de coefficient depuis la mémoire des coefficients w-taps, et les sorties du premier et du second multiplieur sont connectées chacune à une entrée d'un additionneur/soustracteur 5 dont la sortie est connectée à une entrée d'un additionneur final 6, l'autre entrée de cet additionneur recevant, depuis les mémoires de résultats intermédiaires, le résultat y(old) obtenu au cycle précédent, et sa sortie délivrant le résultat de calcul "y" qui correspond au cycle courant. Ces deux additionneurs 1, 2, deux multiplieurs 3, 4 réalisent les accumulations et les multiplications requises pour le calcul de résultats intermédiaires. Chaque multiplieur 3, 4 de 32 bits de précision peut être utilisé comme deux multiplieurs 16 bits, de façon à pouvoir traiter une multiplication complexe à 16 bits tous les cycles, et chaque additionneur 1, 2 comprend deux additionneurs 16 bits. Des mots de 8 bits sont utilisables, chaque opérateur 16 bits pouvant être considéré comme deux opérateurs 8 bits. Ainsi un élément processeur de filtrage peut traiter simultanément jusqu'à vingt quatre opérations 8 bits. Chaque opérateur peut être considéré comme quatre opérateurs 8 bits ou comme deux opérateurs 16 bits en parallèle. Les deux additionneurs 1, 2 sont utilisés quand un filtre est symétrique ; ils sont court-circuités dans les autres cas. L'additionneur-soustracteur 5 est utilisé comme soustracteur lorsque cela est requis par une multiplication complexe, et comme additionneur dans les autres cas.

Un bloc de mise à jour UPD sert à adapter les coefficients dans le cas d'un filtre adaptatif. Il reçoit une donnée "sgn_err", qui est calculée par le processeur hôte dans le cas d'un filtre adaptatif, le signe sgn d'une donnée Xa et une valeur de coefficient w_in issue de la mémoire w-taps, via la connexion 7. Il délivre une valeur de coefficient w_out à mémoriser dans la mémoire des coefficients.

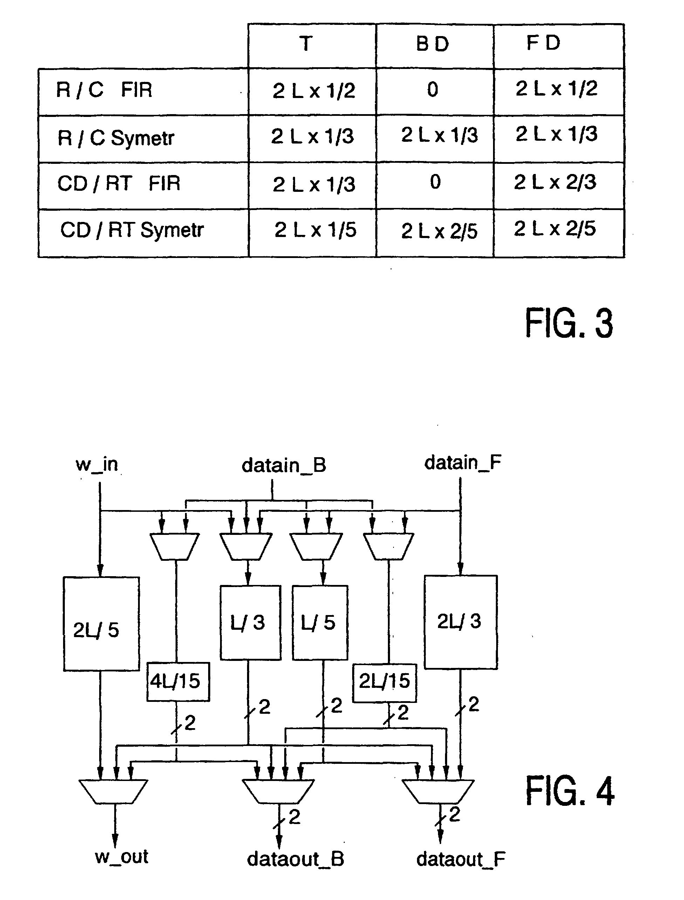

Les différents types de filtres calculés par des processeurs programmables ont des exigences différentes en termes de taille de mémoire pour stocker les données et les coefficients, si bien qu'ils peuvent difficilement utiliser de façon efficace leur mémoire pour tous les types de filtres. En supposant que les mémoires ont une dimension totale 2L, les besoins en taille de mémoire, pour respectivement les données aller, les données retour, et les coefficients, sont indiqués par le tableau de la figure 3. En tête de colonne, les indications FD, BD, T désignent respectivement les données aller, les données retour et les coefficients ; en début de ligne, l'indication "R/C FIR" désigne un filtre FIR avec des données et des coefficients de même type (complexes ou réels) ; l'indication "R/C symetr" désigne un filtre symétrique avec des données et des coefficients de même type (complexes ou réels) ; l'indication "CD/RT FIR" désigne un filtre FIR avec des données complexes et des coefficients réels et l'indication "CD/RT symetr" désigne un filtre symétrique avec des données complexes des coefficients réels. Les données retour ne sont utilisées que dans le cas de filtres symétriques. Les filtres usuels demandent le même montant de mémoire pour les données et pour les coefficients, cependant que les filtres symétriques utilisent deux données pour un coefficient. En outre, une donnée complexe demande deux fois plus de mémoire qu'une donnée réelle. Ainsi, pour les filtres présentés dans la table de la figure 3, la mémoire peut être considérée soit comme deux mémoires de taille identique dans le cas « R/C FIR », trois mémoires de taille identique dans le cas « R/C symetr », ou bien trois mémoires dont deux sont deux fois plus grandes que la troisième dans le cas « CD/RT symetr » et enfin deux mémoires dont l'une est deux fois plus grande que l'autre dans le cas des filtres « CD/RT FIR ». Etant donné que 30 est le plus petit commun multiple entre 2, 3, et 5, on aura besoin de 30 mémoires de taille L/15, pour configurer de façon optimale la mémoire de données et de coefficients.

Une solution complète impliquerait donc 30 mémoires. En fait seulement six mémoires sont utilisées parce que toutes les mémoires qui stockent toujours le même type d'informations ont toujours le même comportement et sont regroupées ensemble. Ces six mémoires ont des dimensions différentes. Ceci est illustré par la figure 4. Le nombre de ports et le nombre de parties dépend des types de filtres supportés et du nombre de multiplieurs dans la partie opératrice.

L'algorithme suivant est utilisé pour regrouper les mémoires :
- étape 1 : constituer un ensemble de cases mémoires appelé segment, en considérant la valeur non nulle la plus petite parmi toutes les valeurs du tableau de la figure 3. Cette valeur correspond à la taille du segment.
- étape 2 : pour chaque type de filtre, déterminer si ce segment contiendra des données aller, des données retour ou des coefficients.
- soustraire la valeur trouvée à l'étape 1 de la plus petite valeur non nulle de chaque colonne.
- répéter les étapes 1 et 2 avec la nouvelle table créée, jusqu'à ce que toutes les valeurs soient nulles.
A l'étape 2, les branchements d'entrée des multiplexeurs sont obtenus. Ainsi, pour chaque type de filtre, chaque mémoire est utilisée par un seul type de données ou de coefficients ; toutes les mémoires qui contiennent le même type de données ou de coefficients peuvent être virtuellement concaténées pour obtenir une unique mémoire virtuelle, pour chaque type de données et coefficients. Les résultats fournis par cet algorithme sont mémorisés.

La génération des adresses pour les mémoires est faite comme si on avait une mémoire pour les données aller, une pour les données retour, et une pour les coefficients. La dimension de la mémoire pour les données retour est nulle si le filtre n'est pas symétrique. En utilisant ces adresses absolues, des adresses relatives peuvent être générées et les mémoires sont sélectionnées en réalisant des soustractions et des comparaisons.

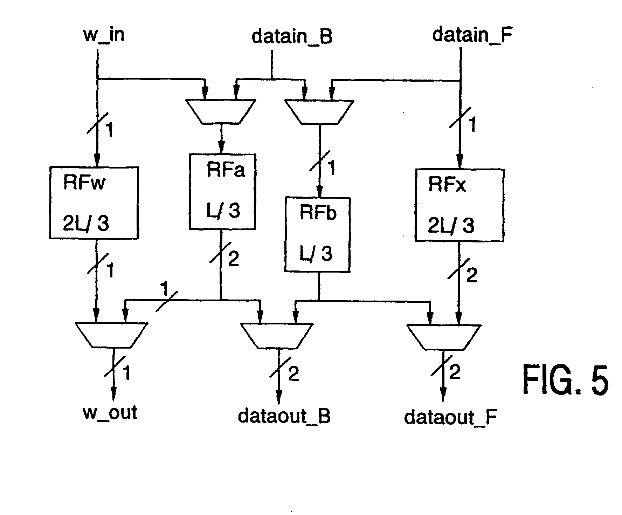

Néanmoins, au prix d'une réduction de l'efficacité de la partition des mémoires, la réalisation peut être plus simple. Ceci est illustré par la figure 5. Parmi les six mémoires de taille L/3 de la figure 4, certaines sont toujours utilisées de la même façon ; elles sont regroupées ici et seulement quatre mémoires sont utilisées. Deux de ces quatre mémoires (RFw et RFx) contiennent 2L/3 mots, et les deux autres (RFa et RFb) contiennent L/3 mots. Dans le cas de filtres à réponse impulsionnelle finie adaptatifs ou à décimation, les coefficients sont placées dans Rfw et Rfa, et les données dans Rfx et Rfb.Dans le cas de filtres symétriques, ou à données complexes avec coefficients réels, les coefficients sont placées dans Rfw et les données dans Rfx, Rfa, et Rfb. Ainsi, des filtres symétriques avec un nombre 4L/3 de données peuvent aussi être réalisés en utilisant toute la capacité des mémoires. Une telle partition n'est toutefois pas optimale dans le cas "CD/RT symetr". Il est clair que d'autres partitions peuvent être imaginées pour d'autres types de filtres.

## Revendications

1. Circuit coprocesseur programmable (CO-PR) destiné à être associé à un processeur principal (PR-H) pour constituer un filtre numérique, circuit comprenant au moins un élément processeur de filtrage (FPE) contenant de la mémoire (x-data, w-taps) pour des données d'entrée (x-data, w-taps) et pour des coefficients, (w-in), au moins un additionneur dont les entrées sont connectées aux sorties de lecture (xa, xb) de la mémoire des données (x-data), et un multiplieur dont une entrée est connectée à une sortie de résultat de l'additionneur et une autre entrée est connectée à une sortie de lecture de la mémoire des coefficients (w-taps), **caractérisé en ce que** la mémoire des données d'entrée (x-data) et celle des coefficients (w-taps) placée dans une mémoire unique qui est partitionnée en plusieurs parties et des moyens sont prévus pour regrouper des parties de façon variable afin d'adapter la mémoire à des filtres différents.

2. Circuit coprocesseur programmable selon la revendication 1, **caractérisé en ce que**, la dimension totale de la mémoire d'un élément processeur de filtrage étant 2L, cette mémoire comprend six sous-mémoires de dimensions respectives 2L/5, 4L/15, L/3, L/5, 2L/15, 2L/3.

3. Circuit coprocesseur programmable selon la revendication 1, **caractérisé en ce que**, la dimension totale de la mémoire d'un élément processeur de filtrage étant 2L, cette mémoire comprend quatre sous-mémoires de dimensions respectives 2L/3, L/3, L/3, 2L/3.

4. Circuit coprocesseur programmable selon la revendication 1, **caractérisé en ce qu'**il comprend des moyens pour déterminer et mémoriser les limites hautes et basses des parties variables des mémoires de données et de coefficients.

## Patentansprüche

1. Programmierbare Koprozessorschaltung (CO-PR) zur Verbindung mit einem Hauptprozessor (PR-H) zur Bildung eines digitalen Filters, Schaltung mit mindestens einem filternden Prozessorelement (FPE) mit einem Speicher (x-data, w-taps) für eingehende Daten (Data_inF, Data_inB) und für Koeffizienten (w-in), mindestens einem Addierer, dessen Eingänge mit den Leseausgängen (xa, xb) des Datenspeichers (x-data) verbunden sind, und einem Multiplizierer, von dem ein Eingang an einen Ergebnisausgang des Addierers angeschlossen ist und ein anderer Eingang an einen Leseausgang des Koeffizientenspeichers (w-taps) angeschlossen ist, **dadurch gekennzeichnet, dass** der Speicher für die Eingangsdaten (x-data) und der für die Koeffizienten (w-taps) in einem einzigen Speicher angebracht ist, der in mehrere Teile aufgeteilt ist, und dass Mittel vorgesehen sind, um die Teile auf variable Weise zu gruppieren, um den Speicher an verschiedene Filter anzupassen.

2. Programmierbare Koprozessorschaltung nach Anspruch 1, **dadurch gekennzeichnet, dass** während die Gesamtabmessung des Speichers eines filternden Prozessorelements 2L ist, dieser Speicher sechs Unterspeicher mit den jeweiligen Abmessungen 2L/5, 4L/15, L/3, L/5, 2L/15, 2L/3 enthält.

3. Programmierbare Koprozessorschaltung nach Anspruch 1, **dadurch gekennzeichnet, dass** während die Gesamtabmessung des Speichers eines filternden Prozessorelements 2L ist, dieser Speicher vier Unterspeicher mit den jeweiligen Abmessungen 2L/3, L/3, L/3, 2L/3 enthält.

4. Programmierbare Koprozessorschaltung nach Anspruch 1, **dadurch gekennzeichnet, dass** sie Mittel zur Bestimmung und Speicherung der oberen und unteren Grenzen der variablen Teile der Daten- und Koeffizientenspeicher enthält. Dessins wenn notwendig

## Claims

1. A programmable co-processor circuit (CO-PR) intended to be associated with a main processor (PR-H) for forming a digital filter, the circuit including at least a filter processor element (FPE) having memory capacity (x-data, w-taps) for input data (Data_inF, Data_inB) and for coefficients (W_in), called "taps", at least an adder whose inputs are connected to the read outputs (Xa, Xb) of the data memory (x-data) and a multiplier of which one input is connected to a result output of the adder and another input is connected to a read output of the taps memory (w-taps), **characterized in that** the input data memory (x-data) and the taps memory (w-taps) are placed in a single memory that is partitioned into various segments, and means are provided for variably combining the segments in order to adapt the memory to different filters.

2. A programmable co-processor circuit as claimed in claim 1, **characterized in that**, with the total dimension of the memory of a filter processor element being 2L, this memory includes six sub-memories having respective dimensions 2L/5, 4L/15, L/3, L/5, 2L/1 5, 2L/3.

3. A programmable co-processor circuit as claimed in claim 1, **characterized in that**, with the total dimension of the memory of a filter processor element being 2L, the memory includes four sub-memories having respective dimensions of 2L,/3, L/3, L/3, 2L/3.

4. A programmable co-processor circuit as claimed in claim 1, **characterized in that** it includes means for determining and storing high and low limits of the variable segments of the data and taps memories.
